# EUROPEAN PATENT SPECIFICATION

(11) **EP 3 121 211 B1**
(45) Date of publication and mention of the grant of the patent: **24.02.2021**
(21) Application number: 15765978.0
(22) Date of filing: 19.03.2015
(51) Int. Cl.: C08G 61/12, C08L 65/00, H01L 31/042, C07D 235/02, C08K 3/04

(54) **POLYMER AND ORGANIC SOLAR CELL COMPRISING SAME**
POLYMER UND ORGANISCHE SOLARZELLE DAMIT
POLYMÈRE ET CELLULE SOLAIRE ORGANIQUE LE COMPRENANT

(30) Priority: 21.03.2014 KR 20140033590
(43) Date of publication of application: 25.01.2017
(73) Proprietor: LG Chem, Ltd., Seoul 150-721 (KR)
(72) Inventor: LIM, Bogyu, Daejeon 305-738 (KR); LEE, Hangken, Daejeon 305-738 (KR); BAE, Jaesoon, Daejeon 305-738 (KR); LEE, Jaechol, Daejeon 305-738 (KR); KIM, Jinseck, Daejeon 305-738 (KR); CHO, Keun, Daejeon 305-738 (KR)
(74) Representative: Hoffmann Eitle
(86) International application number: PCT/KR2015/002655
(87) International publication number: WO 2015/142067

(56) References cited:
- WO-A1-2010/000669
- WO-A1-2015/013747
- CN-A- 102 234 365
- KR-A- 20130 040 830
- KR-A- 20130 090 821
- US-A1- 2013 026 459
- US-A1- 2013 200 355
- YONG ZHANG ET AL: "Increased open circuit voltage in fluorinated benzothiadiazole-based alternating conjugated polymers", CHEMICAL COMMUNICATIONS, vol. 47, no. 39, 1 January 2011 (2011-01-01), page 11026, XP055069989, ISSN: 1359-7345, DOI: 10.1039/c1cc14586j
- STEVE ALBRECHT ET AL: "Fluorinated Copolymer PCPDTBT with Enhanced Open-Circuit Voltage and Reduced Recombination for Highly Efficient Polymer Solar Cells", JOURNAL OF THE AMERICAN CHEMICAL SOCIETY, vol. 134, no. 36, 6 August 2012 (2012-08-06), pages 14932-14944, XP055152146, US ISSN: 0002-7863, DOI: 10.1021/ja305039j
- YONGXI LI ET AL: "Side-Chain Effect on Cyclopentadithiophene/Fluorobenzothiadiazo le-Based Low Band Gap Polymers and Their Applications for Polymer Solar Cells", MACROMOLECULES, vol. 46, no. 14, 28 June 2013 (2013-06-28) , pages 5497-5503, XP055152139, US ISSN: 0024-9297, DOI: 10.1021/ma4009302
- TIANSHI QIN ET AL: "Tailored Donor-Acceptor Polymers with an A-D1-A-D2 Structure: Controlling Intermolecular Interactions to Enable Enhanced Polymer Photovoltaic Devices", JOURNAL OF THE AMERICAN CHEMICAL SOCIETY, vol. 136, no. 16, 4 April 2014 (2014-04-04), pages 6049-6055, XP055406907, US ISSN: 0002-7863, DOI: 10.1021/ja500935d
- THOMAS S. VAN DER POLL ET AL: "Non-Basic High-Performance Molecules for Solution-Processed Organic Solar Cells", ADVANCED MATERIALS, vol. 24, no. 27, 6 June 2012 (2012-06-06), pages 3646-3649, XP055152153, DE ISSN: 0935-9648, DOI: 10.1002/adma.201201127
- KOEN H. HENDRIKS ET AL: "High-Molecular-Weight Regular Alternating Diketopyrrolopyrrole-based Terpolymers for Efficient Organic Solar Cells", ANGEWANDTE CHEMIE INTERNATIONAL EDITION, vol. 52, no. 32, 5 August 2013 (2013-08-05), pages 8341-8344, XP055407069, ISSN: 1433-7851, DOI: 10.1002/anie.201302319
- LEI YING ET AL: "Regioregular Pyridal[2,1,3]thiadiazole [pi]-Conjugated Copolymers", JOURNAL OF THE AMERICAN CHEMICAL SOCIETY, vol. 133, no. 46, 23 November 2011 (2011-11-23), pages 18538-18541, XP055077696, ISSN: 0002-7863, DOI: 10.1021/ja207543g
- JIANHUI HOU ET AL.: 'Bandgap and Molecular Energy Level Control of Conjugated Polymer Photovoltaic Materials Based on Benzo[1,2-b:4,5-b']dithiophene.' MACROMOLECULES vol. 41, 2008, pages 6012 - 6018, XP009136553
- SAMUEL C. PRICE ET AL.: 'Low Band Gap Polymers Based on Benzo[1,2-b:4,5-b']dithiophene: Rational Design of Polymers Leads to High Photovoltaic Performance.' MACROMOLECULES vol. 43, 2010, ISSN 0024-9297 pages 4609 - 4612, XP002642815

## Description

### [Technical Field]

The present specification relates to a polymer and an organic solar cell including the same.

### [Background Art]

An organic solar cell is a device that may directly convert solar energy into electric energy by applying a photovoltaic effect. A solar cell may be divided into an inorganic solar cell and an organic solar cell, depending on the materials constituting a thin film. Typical solar cells are made through a p-n junction by doping crystalline silicon (Si), which is an inorganic semiconductor. Electrons and holes generated by absorbing light diffuse to p-n junction points and move to an electrode while being accelerated by the electric field. The power conversion efficiency in this process is defined as the ratio of electric power given to an external circuit and solar power entering the solar cell, and the efficiency have reached approximately 24% when measured under a currently standardized virtual solar irradiation condition. However, since inorganic solar cells in the related art already have shown the limitation in economic feasibility and material demands and supplies, an organic semiconductor solar cell, which is easily processed and inexpensive and has various functionalities, has come into the spotlight as a long-term alternative energy source.

For the solar cell, it is important to increase efficiency so as to output as much electric energy as possible from solar energy. In order to increase the efficiency of this solar cell, it is important to generate as many excitons as possible inside a semiconductor, but it is also important to pull the generated charges to the outside without loss. One of the reasons for the charge loss is the dissipation of generated electrons and holes due to recombination. Various methods have been proposed to deliver generated electrons and holes to an electrode without loss, but additional processes are required in most cases and accordingly, manufacturing costs may be increased.

### [Citation List]

### [Patent Document]

US 5331183
US 5454880

Each of Chemical Communications, vol. 47, no. 39 (2011), pages 11026-11028, J of the American Chemical Society, vol. 134, no. 36, (2012), pages 14932-14944, Macromolecules, vol. 46, no. 14 (2013), pages 5497-5503 and US-A-2013/200355 discloses regio-random polymers prepared from mono-substituted benzothiadiazoles (BTD) bearing substituents such as fluorine at the 5-position of the BTD ring system.

US 2013/00264591 A1 discloses the preparation of alternating copolymers comprising benzodithiazole and dithienopyran units.

### [Detailed Description of the Invention]

### [Technical Problem]

An object of the present specification is to provide a polymer and an organic solar cell including the same.

### [Technical Solution]

According to a first aspect, the present invention provides a polymer represented by any one of the following Formulae 1-1 to 1-3: 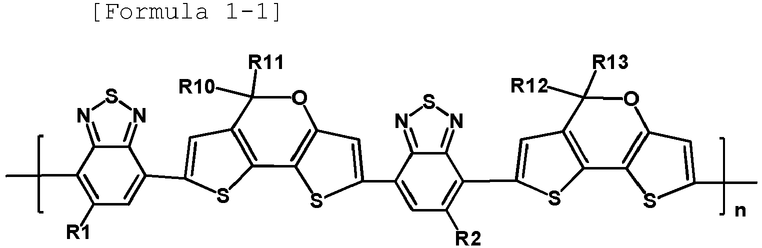 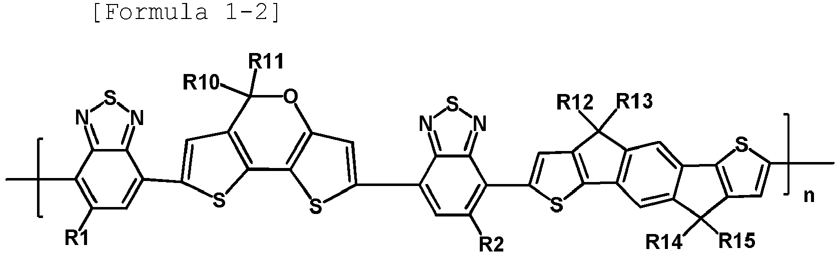 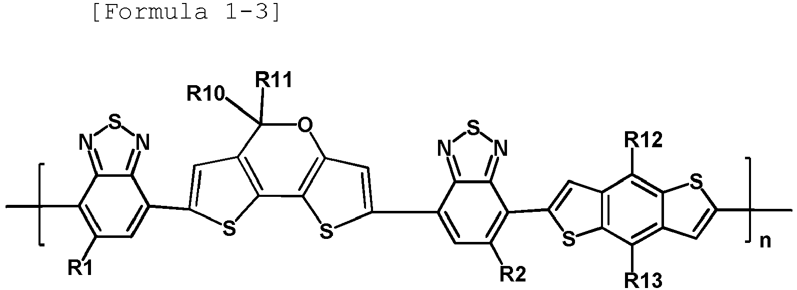 wherein n is an integer of up to 100,000, R1 and R2 are fluorine, and R10 to R15 are the same as or different from each other, and are each independently a substituted or unsubstituted straight-chained or branched alkyl group; a substituted or unsubstituted straight-chained or branched alkoxy group; a substituted or unsubstituted cycloalkyl group; a substituted or unsubstituted aryl group; or a substituted or unsubstituted heterocyclic group; wherein the expression substituted or unsubstituted above means being substituted with one or more substituents selected from deuterium; a halogen group; an alkyl group; an alkenyl group; an alkoxy group; an ester group; a carbonyl group; a carboxyl group; a hydroxyl group; a cycloalkyl group; a silyl group; an arylalkenyl group; an aryloxy group; an alkylthioxy group; an alkylsulfoxy group; an arylsulfoxy group; a boron group; an alkylamine group; an aralkylamine group; an arylamine group; an aryl group; a nitrile group; a nitro group; and a heterocyclic group; or having no substituent.

According to a second aspect, the present invention provides an organic solar cell comprising a first electrode, a second electrode provided to face the first electrode, and one or more organic material layers provided between the first electrode and the second electrode and comprising a photoactive layer. One or more layers of the organic material layers comprises the copolymer as defined in the above first aspect.

### [Advantageous Effects]

The polymer according to an exemplary embodiment of the present specification has regio-regularity in which R1 and R2 are substituted at a predetermined position. The polymer having the regio-regularity according to an exemplary embodiment of the present specification is relatively excellent in crystallinity.

In addition, for the polymer according to an exemplary embodiment of the present specification, it is easy to control the bandgap and/or the energy levels of the highest occupied molecular orbital (HOMO) and the lowest unoccupied molecular orbital (LUMO) of the polymer by introducing substituted polycyclic divalent heterocyclic groups (hereafter referred to as "A" and "B") in addition to the heterocyclic groups including two N's.

The polymer according to an exemplary embodiment of the present specification may be used as a material for an organic material layer of an organic solar cell, and an organic solar cell including the same may exhibit characteristics which are excellent in an increase in open-circuit voltage and short-circuit current and/or an increase in efficiency, and the like.

The polymer according to an exemplary embodiment of the present specification may be used either alone or in mixture with other materials in an organic solar cell, and it may be expected to enhance the efficiency, and enhance the service life of a device by characteristics such as thermal stability of the compound.

### [Brief Description of Drawings]

FIG. 1 is a view illustrating an organic solar cell according to an exemplary embodiment of the present specification.
FIG. 2 is a view illustrating high performance liquid chromatography (HPLC) of the compound prepared in Example 1.
FIG. 3 is a view illustrating the NMR spectrum of the compound prepared in Example 1.
FIG. 4 is a view illustrating the UV spectrum of the polymer prepared in Comparative Example 1.
FIG. 5 is a view illustrating the electrochemical measurement result (cyclic voltammetry) of the polymer prepared in Comparative Example 1.
FIG. 6 is a view illustrating the UV spectrum of the polymer prepared in Example 3.
FIG. 7 is a view illustrating the electrochemical measurement result (cyclic voltammetry) of the polymer prepared in Example 3.
FIG. 8 is a view illustrating the UV spectrum of the polymer prepared in Example 4.
FIG. 9 is a view illustrating the electrochemical measurement result (cyclic voltammetry) of the polymer prepared in Example 4.
FIG. 10 is a view illustrating the current density according to the voltage of an organic solar cell including the polymer of Comparative Example 1.
FIG. 11 is a view illustrating the current density according to the voltage of an organic solar cell including the polymer of Example 2.
FIG. 12 is a view illustrating the current density according to the voltage of an organic solar cell including the polymer of Example 3.

### [Explanation of Reference Numerals and Symbols]

101: Substrate
102: First electrode
103: Hole transport layer
104: Photoactive layer
105: Second electrode

### [Best Mode]

Hereinafter, the present specification will be described in detail.

In the present specification, the 'unit' means a repeated structure included in a monomer of a polymer, and a structure in which the monomer is bonded to the polymer by polymerization.

In the present specification, the meaning of 'including a unit' means that the unit is included in a main chain in the polymer.

A polymer according to an exemplary embodiment of the present specification has a regio-regularity in which A is provided between two heterocyclic groups including at least two N's, and R1 and R2 are substituted at a position which is relatively far from A. In this case, the crystallinity is excellent.

The regio-regularity in the present specification means that a substituent is selectively provided in a predetermined direction in a structure in the polymer.

In an exemplary embodiment of the present specification, it is easy to control the energy levels of the bandgap and/or the highest occupied molecular orbital (HOMO) and the lowest unoccupied molecular orbital (LUMO) of the polymer by controlling the structure of A and B.

R1 and R2 both represent fluorine. Such a compound may be easily prepared by increasing the selectivity of a reaction in a polymer including a unit represented by Formula 1, which is substituted with R1 and R2, and the prepared polymer is excellent in crystallinity, so that the charge mobility may be increased in an organic electronic device such as an organic solar cell, an organic light emitting device, and an organic transistor.

Furthermore, the absolute value of the highest occupied molecular orbital (HOMO) energy level of the polymer is increased by introducing R1 and R2, so that it may be expected that the open voltage is increased.

In an exemplary embodiment of the present specification, A and B act as an electron donor in the polymer.

When A and B act as an electron donor, a push-pull effect is expected along with the heterocyclic groups including two N's, which relatively acts as an electron acceptor. In this case, since a low-bandgap is formed, and the positions of the substituents of R1 and R2 have predetermined directionality based on A or B, the polymer has excellent crystallinity and/or improved charge mobility.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

The term "substituted or unsubstituted" as used herein means being substituted with one or more substituents selected from the group consisting of deuterium; a halogen group; an alkyl group; an alkenyl group; an alkoxy group; an ester group; a carbonyl group; a carboxyl group; a hydroxyl groupa cycloalkyl group; a silyl group; an arylalkenyl group; an aryloxy group; an alkylthioxy group; an alkylsulfoxy group; an arylsulfoxy group; a boron group; an alkylamine group; an aralkylamine group; an arylamine group; a heterocyclic group; an arylamine group; an aryl group; a nitrile group; a nitro group; a hydroxyl group; and a heterocyclic group, or having no substituent.

The substituents may be unsubstituted or substituted with an additional substituent.

In the present specification, the halogen group may be fluorine, chlorine, bromine or iodine.

In the present specification, the number of carbon atoms of the imide group is not particularly limited, but is preferably 1 to 25. Specifically, the imide group may be a compound having the following structure, but is not limited thereto.

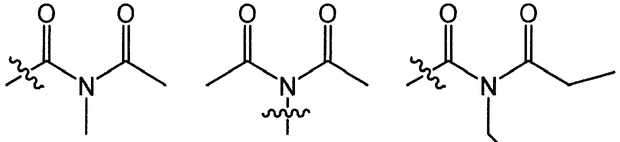

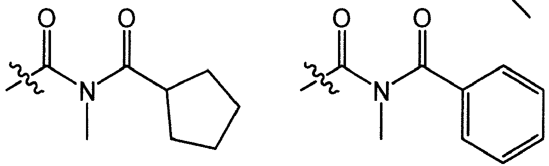

In the present specification, for the amide group, one or two nitrogen of the amide group may be substituted with hydrogen, a straight-chained, branched, or cyclic alkyl group having 1 to 25 carbon atoms, or an aryl group having 6 to 25 carbon atoms. Specifically, the amide group may be a compound having the following structural formula, but is not limited thereto.

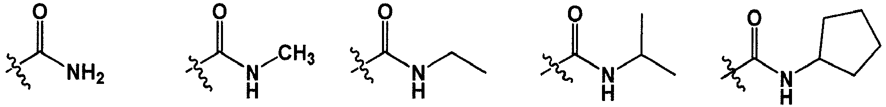

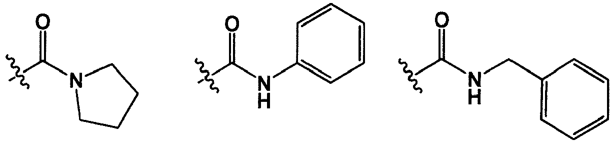

In the present specification, the alkyl group may be straight-chained or branched, and the number of carbon atoms thereof is not particularly limited, but is preferably 1 to 50. Specific examples thereof include methyl, ethyl, propyl, n-propyl, isopropyl, butyl, n-butyl, isobutyl, tert-butyl, sec-butyl, 1-methyl-butyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present specification, the cycloalkyl group is not particularly limited, but is preferably a cycloalkyl group having 3 to 60 carbon atoms, and specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present specification, the alkoxy group may be straight-chained, branched, or cyclic. The number of carbon atoms of the alkoxy group is not particularly limited, but is preferably 1 to 20. Specific examples thereof include methoxy, ethoxy, n-propoxy, isopropoxy, i-propyloxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present specification, the alkenyl group may be straight-chained or branched, and the number of carbon atoms thereof is not particularly limited, but is preferably 2 to 40. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present specification, specific examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

In the present specification, the aryl group may be a monocyclic aryl group or a polycyclic aryl group, and includes the case where an alkyl group having 1 to 25 carbon atoms or an alkoxy group having 1 to 25 carbon atoms is substituted. Further, the aryl group in the present specification may mean an aromatic ring.

When the aryl group is a monocyclic aryl group, the number of carbon atoms thereof is not particularly limited, but is preferably 6 to 25. Specific examples of the monocyclic aryl group include a phenyl group, a biphenyl group, a terphenyl group, and the like, but are not limited thereto.

When the aryl group is a polycyclic aryl group, the number of carbon atoms thereof is not particularly limited, but is preferably 10 to 24. Specific examples of the polycyclic aryl group include a naphthyl group, an anthracenyl group, a phenanthryl group, a pyrenyl group, a perylenyl group, a chrysenyl group, a fluorenyl group, and the like, but are not limited thereto.

In the present specification, the fluorenyl group may be substituted, and adjacent substituents may combine with each other to form a ring.

When the fluorenyl group is substituted, the fluorenyl group may be 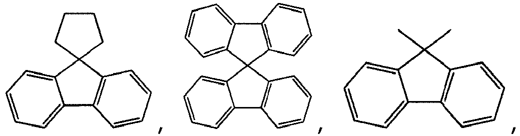 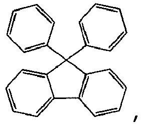 and the like. However, the fluorenyl group is not limited thereto.

In the present specification, a heterocyclic group is a heterocyclic group including one or more of O, N, and S as a hetero element, and the number of carbon atoms thereof is not particularly limited, but is preferably 2 to 60. Examples of the heterocyclic group include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a qinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazole group, a benzocarbazole group, a benzothiophene group, a dibenzothiophene group, a benzofuranyl group, a phenanthroline group, a thiazolyl group, an isoxazolyl group, an oxadiazolyl group, a thiadiazolyl group, a benzothiazolyl group, a phenothiazinyl group, a dibenzofuranyl group, and the like, but are not limited thereto.

The heterocyclic group may be monocyclic or polycyclic, and may be an aromatic ring, an aliphatic ring, or a condensed ring of the aromatic ring and the aliphatic ring.

In the present specification, examples of the arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include a monocyclic aryl group, a polycyclic aryl group, or both a monocyclic aryl group and a polycyclic aryl group.

Specific examples of the arylamine group include phenylamine, naphthylamine, biphenylamine, anthracenylamine, 3-methyl-phenylamine, 4-methyl-naphthylamine, 2-methyl-biphenylamine, 9-methyl-anthracenylamine, a diphenylamine group, a phenylnaphthylamine group, a ditolylamine group, a phenyltolylamine group, carbazole, a triphenylamine group, and the like, but are not limited thereto.

In the present specification, the heteroaryl group in the heteroarylamine group may be selected from the above-described examples of the heterocyclic group.

In the present specification, the aryl group in the aryloxy group, the arylthioxy group, the arylsulfoxy group, and the aralkylamine group is the same as the above-described examples of the aryl group. Specifically, examples of the aryloxy group include phenoxy, p-tolyloxy, m-tolyloxy, 3,5-dimethyl-phenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, 9-phenanthryloxy, and the like, examples of the arylthioxy group include a phenylthioxy group, a 2-methylphenylthioxy group, a 4-tert-butylphenylthioxy group, and the like, and examples of the arylsulfoxy group include a benzenesulfoxy group, a p-toluenesulfoxy group, and the like, but are not limited thereto.

In the present specification, the alkyl group in the alkylthioxy group and the alkylsulfoxy group is the same as the above-described examples of the alkyl group. Specifically, examples of the alkylthioxy group include a methylthioxy group, an ethylthioxy group, a tert-butylthioxy group, a hexylthioxy group, an octylthioxy group, and the like, and examples of the alkylsulfoxy group include mesyl, an ethylsulfoxy group, a propylsulfoxy group, a butylsulfoxy group, and the like, but are not limited thereto.

In an exemplary embodiment of the present specification, R10 to R15 are the same as or different from each other, and are each independently a substituted or unsubstituted alkyl group; or a substituted or unsubstituted aryl group.

In an exemplary embodiment of the present specification, R10 is a substituted or unsubstituted branched alkyl group.

In an exemplary embodiment of the present specification, R10 is a substituted or unsubstituted 3,7-dimethyloctyl group.

In an exemplary embodiment of the present specification, R10 is a 3,7-dimethyloctyl group.

In an exemplary embodiment of the present specification, R11 is a substituted or unsubstituted branched alkyl group.

In an exemplary embodiment of the present specification, R11 is a substituted or unsubstituted 3,7-dimethyloctyl group.

In an exemplary embodiment of the present specification, R11 is a 3,7-dimethyloctyl group.

In an exemplary embodiment of the present specification, R12 is a substituted or unsubstituted branched alkyl group.

In an exemplary embodiment of the present specification, R12 is a substituted or unsubstituted 3,7-dimethyloctyl group.

In an exemplary embodiment of the present specification, R12 is a 3,7-dimethyloctyl group.

In an exemplary embodiment of the present specification, R12 is a substituted or unsubstituted aryl group.

In an exemplary embodiment of the present specification, R12 is a substituted or unsubstituted phenyl group.

In an exemplary embodiment of the present specification, R12 is a phenyl group substituted with a substituted or unsubstituted alkyl group.

In an exemplary embodiment of the present specification, R12 is a phenyl group substituted with an alkyl group.

In an exemplary embodiment of the present specification, R12 is a phenyl group substituted with a hexyl group.

In an exemplary embodiment of the present specification, R12 is a substituted or unsubstituted heterocyclic group.

In another exemplary embodiment, R12 is a substituted or unsubstituted heterocyclic group including one or more S atoms.

In still another exemplary embodiment, R12 is a substituted or unsubstituted thiophene group.

In an exemplary embodiment of the present specification, R12 is a thiophene group unsubstituted or substituted with an alkyl group.

In an exemplary embodiment of the present specification, R12 is a thiophene group substituted with an alkyl group having 1 to 30 carbon atoms.

In another exemplary embodiment of the present specification, R12 is a thiophene group substituted with a 2-ethylhexyl group.

In an exemplary embodiment of the present specification, R13 is a substituted or unsubstituted branched alkyl group.

In an exemplary embodiment of the present specification, R13 is a substituted or unsubstituted 3,7-dimethyloctyl group.

In an exemplary embodiment of the present specification, R13 is a 3,7-dimethyloctyl group.

In an exemplary embodiment of the present specification, R13 is a substituted or unsubstituted aryl group.

In an exemplary embodiment of the present specification, R13 is a substituted or unsubstituted phenyl group.

In an exemplary embodiment of the present specification, R13 is a phenyl group substituted with a substituted or unsubstituted alkyl group.

In an exemplary embodiment of the present specification, R13 is a phenyl group substituted with an alkyl group.

In an exemplary embodiment of the present specification, R13 is a phenyl group substituted with a hexyl group.

In an exemplary embodiment of the present specification, R13 is a substituted or unsubstituted heterocyclic group.

In another exemplary embodiment, R13 is a substituted or unsubstituted heterocyclic group including one or more S atoms.

In still another exemplary embodiment, R13 is a substituted or unsubstituted thiophene group.

In an exemplary embodiment of the present specification, R13 is a thiophene group unsubstituted or substituted with an alkyl group.

In an exemplary embodiment of the present specification, R13 is a thiophene group substituted with an alkyl group having 1 to 30 carbon atoms.

In another exemplary embodiment of the present specification, R13 is a thiophene group substituted with a 2-ethylhexyl group.

In an exemplary embodiment of the present specification, R14 is a substituted or unsubstituted aryl group.

In an exemplary embodiment of the present specification, R14 is a substituted or unsubstituted phenyl group.

In an exemplary embodiment of the present specification, R14 is a phenyl group substituted with a substituted or unsubstituted alkyl group.

In an exemplary embodiment of the present specification, R14 is a phenyl group substituted with an alkyl group.

In an exemplary embodiment of the present specification, R14 is a phenyl group substituted with a hexyl group.

In an exemplary embodiment of the present specification, R15 is a substituted or unsubstituted aryl group.

In an exemplary embodiment of the present specification, R15 is a substituted or unsubstituted phenyl group.

In an exemplary embodiment of the present specification, R15 is a phenyl group substituted with a substituted or unsubstituted alkyl group.

In an exemplary embodiment of the present specification, R15 is a phenyl group substituted with an alkyl group.

In an exemplary embodiment of the present specification, R15 is a phenyl group substituted with a hexyl group.

In an exemplary embodiment of the present specification, the polymer is represented by the following Formulae 1-1-1 to 1-3-1.

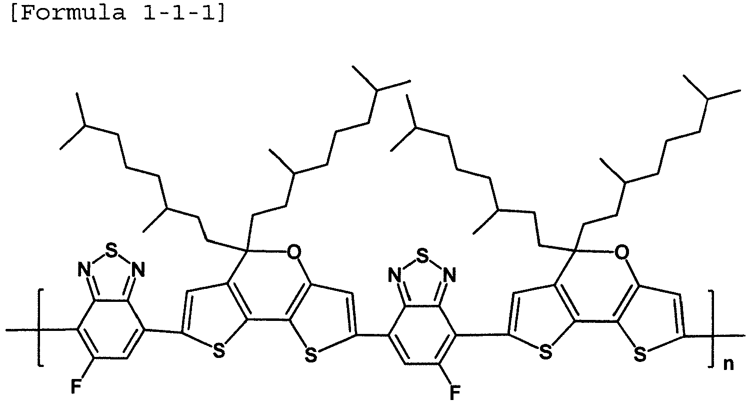

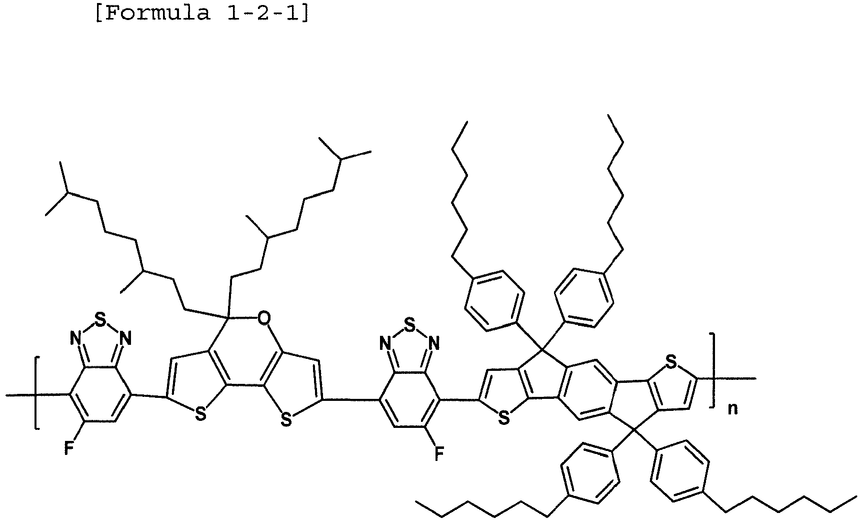

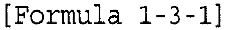

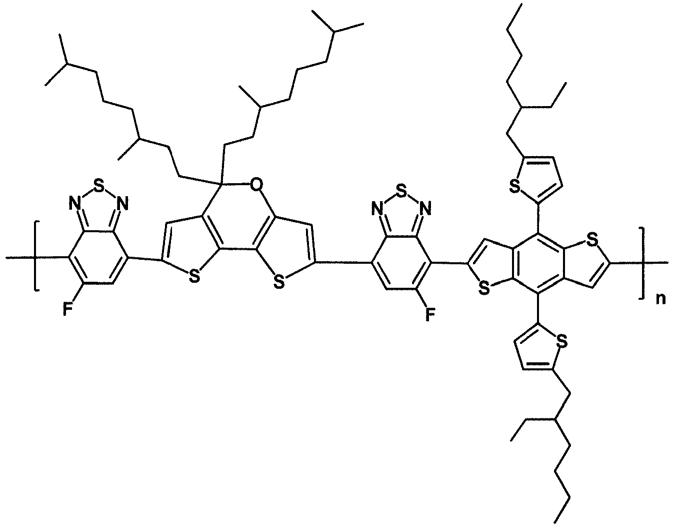

In an exemplary embodiment of the present specification, an end group of the polymer is a heterocyclic group or an aryl group.

In an exemplary embodiment of the present specification, an end group of the polymer is a 4-(trifluoromethyl)phenyl group.

In an exemplary embodiment of the present specification, an end group of the polymer is a bromothiophene group.

In another exemplary embodiment, an end group of the polymer is a bromo-benzene group.

In another exemplary embodiment, an end group of the polymer is a trialkyl(thiophene-2-yl)stannyl group.

The trialkyl in the present specification may be trimethyl or tributyl.

According to an exemplary embodiment of the present specification, a number average molecular weight of the polymer is preferably 500 g/mol to 1,000,000 g/mol. Preferably, a number average molecular weight of the polymer is preferably 10,000 to 100,000. In an exemplary embodiment of the present specification, a number average molecular weight of the polymer is 30,000 to 100,000.

According to an exemplary embodiment of the present specification, the polymer may have a molecular weight distribution of 1 to 100. Preferably, the polymer has a molecular weight distribution of 1 to 3.

The lower the molecular weight distribution is and the higher the number average molecular weight becomes, the better electrical characteristics and mechanical characteristics become.

Further, the number average molecular weight is preferably 100,000 or less, such that the polymer has predetermined or more solubility, and thus, a solution application method is advantageously applied.

The polymer may be prepared based on the Preparation Examples to be described below.

In addition to the polymers represented by Formulae 1-1-1 and 1-2-1, polymers of the present invention may be prepared by putting 1 equivalent of each of a monomer of a heterocyclic group in which R1 is substituted-A-a heterocyclic group in which R2 is substituted and a monomer B, reacting 0.02 equivalent of tris(dibenzylideneacetone)dipalladium(0) (Pd₂(dba)₃) and 0.08 equivalent of triphenylphosphine with the mixture, and purifying the resulting product.

The polymer according to the present specification may be prepared by a multi-step chemical reaction. Monomers are prepared through an alkylation reaction, a Grignard reaction, a Suzuki coupling reaction, a Stille coupling reaction, and the like, and then final polymers may be prepared through a carbon-carbon coupling reaction such as a Stille coupling reaction. When the substituent to be introduced is boronic acid or a boronic ester compound, the polymer may be prepared through a Suzuki coupling reaction, and when the substituent to be introduced is a tributyltin or trimethyltin compound, the polymer may be prepared through a Stille coupling reaction, but the method is not limited thereto.

An exemplary embodiment of the present specification provides an organic solar cell including: a first electrode; a second electrode provided to face the first electrode; and one or more organic material layers provided between the first electrode and the second electrode and including a photoactive layer, in which one or more layers of the organic material layers include the polymer.

The organic solar cell according to an exemplary embodiment of the present specification includes a first electrode, a photoactive layer, and a second electrode. The organic solar cell may further include a substrate, a hole transport layer, and/or an electron transport layer.

In an exemplary embodiment of the present specification, when the organic solar cell accepts a photon from an external light source, an electron and a hole are generated between an electron donor and an electron acceptor. The generated hole is transported to a positive electrode through an electron donor layer.

In an exemplary embodiment of the present specification, the organic material layer includes a hole transport layer, a hole injection layer, or a layer which simultaneously transports and injects holes, and the hole transport layer, the hole injection layer, or the layer which simultaneously transports and injects holes includes the polymer.

In another exemplary embodiment, the organic material layer includes an electron injection layer, an electron transport layer, or a layer which simultaneously injects and transports electrons, and the electron injection layer, the electron transport layer, or the layer which simultaneously injects and transports electrons includes the polymer.

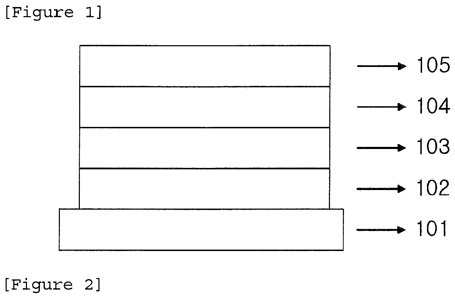

FIG. 1 is a view illustrating an organic solar cell according to an exemplary embodiment of the present specification.

In an exemplary embodiment of the present specification, when the organic solar cell accepts a photon from an external light source, an electron and a hole are generated between an electron donor and an electron acceptor. The generated hole is transported to a positive electrode through an electron donor layer.

In an exemplary embodiment of the present specification, the organic solar cell may further include an additional organic material layer. The organic solar cell may reduce the number of organic material layers therein by using an organic material which simultaneously has various functions.

In an exemplary embodiment of the present specification, the first electrode is an anode, and the second electrode is a cathode. In another exemplary embodiment, the first electrode is a cathode, and the second electrode is an anode.

In an exemplary embodiment of the present specification, in the organic solar cell, a cathode, a photoactive layer, and an anode may be arranged in this order, and an anode, a photoactive layer, and a cathode may be arranged in this order, but the arrangement order is not limited thereto.

In another exemplary embodiment, in the organic solar cell, the anode, the hole transport layer, the photoactive layer, the electron transport layer, and the cathode may also be arranged in this order, and the cathode, the electron transport layer, the photoactive layer, the hole transport layer, and the anode may also be arranged in this order, but the arrangement order is not limited thereto.

In an exemplary embodiment of the present specification, the organic solar cell has a normal structure.

In an exemplary embodiment of the present specification, the organic solar cell has an inverted structure.

In an exemplary embodiment of the present specification, the organic solar cell has a tandem structure.

The organic solar cell according to an exemplary embodiment of the present specification may have one or two or more photoactive layers.

In another exemplary embodiment, a buffer layer may be provided between the photoactive layer and the hole transport layer, or between the photoactive layer and the electron transport layer. In this case, a hole injection layer may be further provided between the anode and the hole transport layer. Further, an electron injection layer may be further provided between the cathode and the electron transport layer.

In an exemplary embodiment of the present specification, the photoactive layer includes one or two or more selected from the group consisting of an electron donor and an electron acceptor, and the electron donor material includes the polymer.

In an exemplary embodiment of the present specification, the electron acceptor material may be selected from the group consisting of fullerene, fullerene derivatives, bathocuproine, semi-conducting elements, semi-conducting compounds, and combinations thereof. Specifically, the electron acceptor material is one or two or more compounds selected from the group consisting of fullerene, fullerene derivatives ((6,6)-phenyl-C61-butyric acid-methylester (PCBM) or (6,6)-phenyl-C61-butyric acid-cholesteryl ester (PCBCR)), perylene, polybenzimidazole (PBI), and 3,4,9,10-perylene-tetracarboxylic bis-benzimidazole (PTCBI).

In an exemplary embodiment of the present specification, the electron donor and the electron acceptor constitute a bulk heterojunction (BHJ).

The bulk heterojunction means that an electron donor material and an electron acceptor material are mixed with each other in a photoactive layer.

In an exemplary embodiment of the present specification, the photoactive layer has a bilayer thin film structure including an n-type organic material layer and a p-type organic material layer, and the p-type organic material layer includes the polymer.

In the present specification, the substrate may be a glass substrate or a transparent plastic substrate having excellent transparency, surface smoothness, handleability, and waterproofing properties, but is not limited thereto, and the substrate is not limited as long as the substrate is typically used in the organic solar cell. Specific examples thereof include glass or polyethylene terephthalate (PET), polyethylene naphthalate (PEN), polypropylene (PP), polyimide (PI), triacetyl cellulose (TAC), and the like, but are not limited thereto.

The anode electrode may be made of a material which is transparent and has excellent conductivity, but is not limited thereto. Examples thereof include: a metal, such as vanadium, chromium, copper, zinc, and gold, or alloys thereof; a metal oxide, such as zinc oxide, indium oxide, indium tin oxide (ITO), and indium zinc oxide (IZO); a combination of metal and oxide, such as ZnO:Al or SnO₂:Sb; an electrically conductive polymer, such as poly(3-methylthiophene), poly[3,4-(ethylene-1,2-dioxy)thiophene] (PEDOT), polypyrrole, and polyaniline, and the like, but are not limited thereto.

A method of forming the anode electrode is not particularly limited, but the anode electrode may be formed, for example, by being applied onto one surface of a substrate using sputtering, e-beam, thermal deposition, spin coating, screen printing, inkjet printing, doctor blade, or a gravure printing method, or by being coated in the form of a film.

When the anode electrode is formed on a substrate, the anode electrode may be subjected to processes of cleaning, removing moisture, and hydrophilic modification.

For example, a patterned ITO substrate is sequentially cleaned with a cleaning agent, acetone, and isopropyl alcohol (IPA), and then dried on a hot plate at 100 to 150°C for 1 to 30 minutes, preferably at 120°C for 10 minutes in order to remove moisture, and when the substrate is completely cleaned, the surface of the substrate is hydrophilically modified.

Through the surface modification as described above, the junction surface potential may be maintained at a level suitable for a surface potential of a photoactive layer. Further, during the modification, a polymer thin film may be easily formed on an anode electrode, and the quality of the thin film may also be improved.

Examples of a pre-treatment technology for an anode electrode include a) a surface oxidation method using a parallel plate-type discharge, b) a method of oxidizing the surface through ozone produced by using UV (ultraviolet) rays in a vacuum state, c) an oxidation method using oxygen radicals produced by plasma, and the like.

One of the methods may be selected depending on the state of the anode electrode or the substrate. However, in all the methods, it is preferred to prevent oxygen from being separated from the surface of the anode electrode or the substrate, and maximally inhibit moisture and organic materials from remaining. In this case, it is possible to maximize a substantial effect of the pre-treatment.

As a specific example, it is possible to use a method of oxidizing the surface through ozone produced by using UV. In this case, a patterned ITO substrate after being ultrasonically cleaned is baked on a hot plate and dried well, and then introduced into a chamber, and the ITO substrate patterned may be cleaned by ozone generated by reacting an oxygen gas with UV light by operating a UV lamp.

However, the surface modification method of the ITO substrate patterned in the present specification needs not be particularly limited, and any method may be used as long as the method is a method of oxidizing a substrate.

The cathode electrode may be a metal having a low work function, but is not limited thereto. Specific examples thereof include: a metal, such as magnesium, calcium, sodium, potassium, titanium, indium, yttrium, lithium, gadolinium, aluminum, silver, tin, and lead, or alloys thereof; and a multi-layered material, such as LiF/Al, LiO₂/Al, LiF/Fe, Al:Li, Al:BaF₂, and Al:BaF₂:Ba, but are not limited thereto.

The cathode electrode may be deposited and formed in a thermal evaporator showing a vacuum degree of 5 x 10⁻⁷ torr or less, but the forming method is not limited to this method.

The hole transport layer and/or electron transport layer materials serve to efficiently transfer electrons and holes separated from a photoactive layer to the electrode, and the materials are not particularly limited.

The hole transport layer material may be poly(3,4-ethylenediocythiophene) doped with poly(styrenesulfonic acid) (PEDOT:PSS) and molybdenum oxide (MoOₓ); vanadium oxide (V₂O₅); nickel oxide (NiO); and tungsten oxide (WOₓ), and the like, but is not limited thereto.

The electron transport layer material may be electron-extracting metal oxides, and specific examples thereof include: a metal complex of 8-hydroxyquinoline; a complex including Alq₃; a metal complex including Liq; LiF; Ca; titanium oxide (TiOₓ); zinc oxide (ZnO); and cesium carbonate (Cs₂CO₃), and the like, but are not limited thereto.

The photoactive layer may be formed by dissolving a photoactive material such as an electron donor and/or an electron acceptor in an organic solvent, and then applying the solution by a method such as spin coating, dip coating, screen printing, spray coating, doctor blade, and brush painting, but the forming method is not limited thereto.

A preparation method of the polymer and the manufacture of an organic solar cell including the same will be described in detail in the following Preparation Examples and Examples. However, the following Examples are provided for exemplifying the present specification, and the scope of the present specification is not limited thereby.

### Example 1. Synthesis of Monomer A

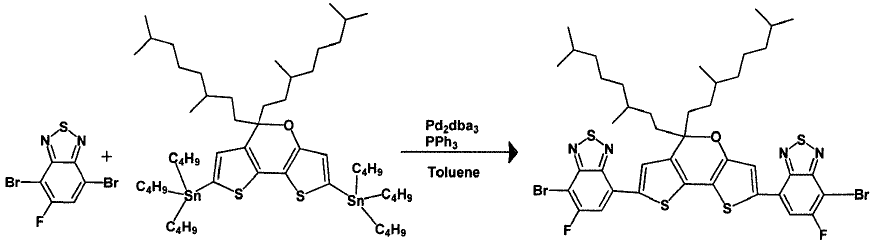

3.1195 g (10 mmol) of 4,7-dibromo-5-fluorobenzo[c] [1,2,5]thiadiazole (FBTBr₂), 4.2116 g (4 mmol) of a monomer into which stannyl (Sn) is introduced, 0.733 g (0.08 mmol) of a tris(dibenzylideneacetone)dipalladium(0) (Pd₂(dba)₃) catalyst, and 0.084 g (0.32 mmol) of triphenylphosphine were put into a flask, the mixture was degassed, and then 100 ml of toluene was added thereto, and the resulting mixture was reacted at 80°C for 48 hours. After the reaction, a final compound was obtained by extracting the mixture with dichloromethane, removing the solvent under reduced pressure, and subjecting a crude product to silica column purification at a ratio of hexane : dichloromethane = 4 : 1. (dark solid, yield: 35%)

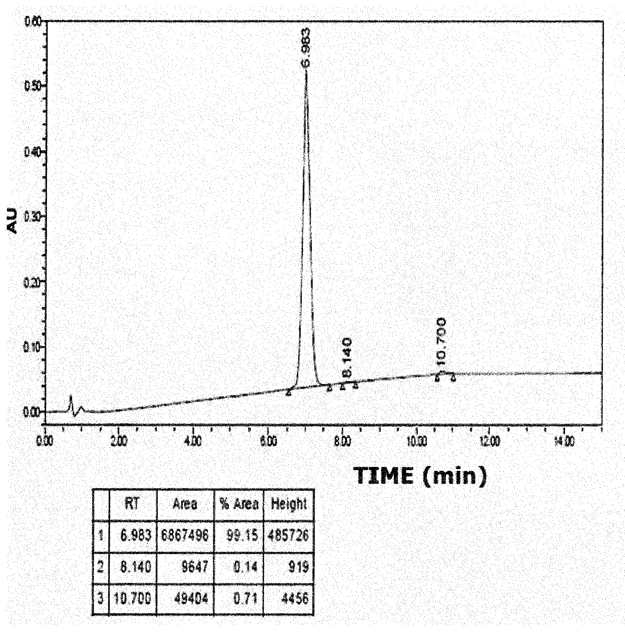

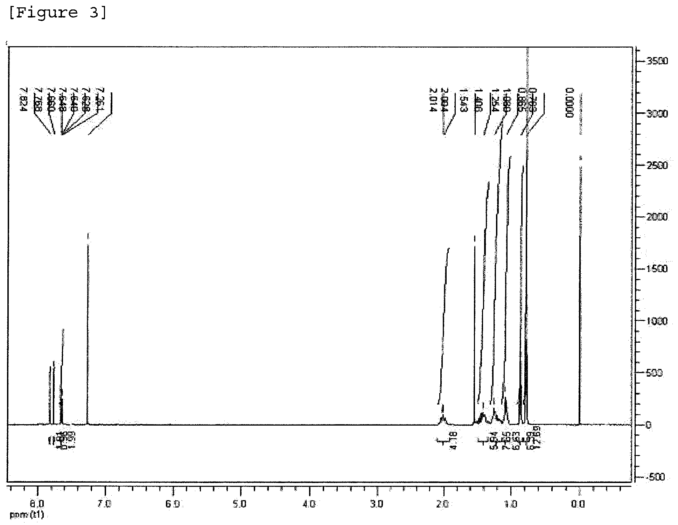

FIG. 2 is a view illustrating high performance liquid chromatography (HPLC) of the compound prepared in Example 1. FIG. 3 is a view illustrating the NMR spectrum of the compound prepared in Example 1.

### Example 2. Synthesis of Formula 1-1-1

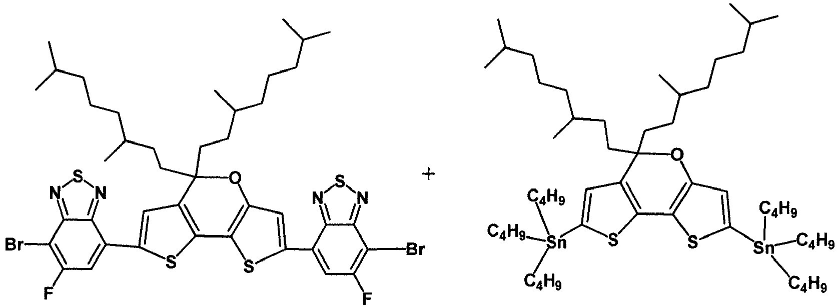

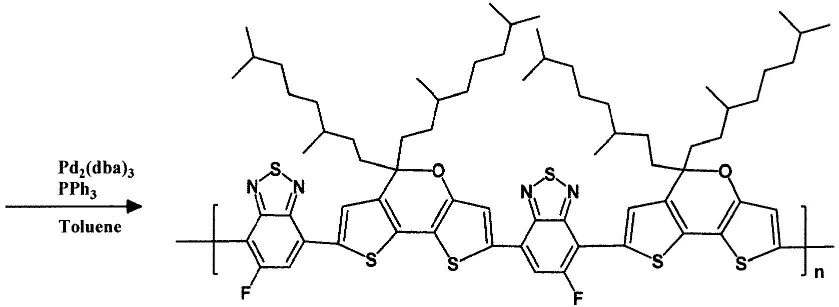

1 mmol of the monomer of Example 1, 1 mmol of an electron donor monomer into which Sn had been introduced, 0.02 mmol of tris(dibenzylideneacetone)dipalladium(0) (Pd₂(dba)₃), and 0.08 mmol of triphenylphosphine were put into a microwave dedicated container, and the mixture was degassed for 5 minutes three times.

And then, 20 mL of dried toluene and 1 mL of dried dimethylformamide (DMF) were added thereto, the mixture was reacted at 120°C for 10 minutes, at 140°C for 10 minutes, and at 150°C for 1 hour, and then cooled to normal temperature, an endcapper was added thereto, and the resulting mixture was reacted at 150°C for 1 hour.

After the reaction, the reaction solution was precipitated in a 1:1 solution of methanol and 1 M hydrochloric acid (HCl), and then filtered, the filtered polymer was dissolved in chlorobenzene, the dissolved solution was mixed with ethylene diamine tetraacetic acid (EDTA) + water (H₂O), and the resulting mixture was reacted at 100°C for 2 hours. After the reaction, the organic layer was separated and washed with water, and then again washed twice with a 3 wt% acetic acid and again with a 5% potassium fluoride, and then an obtained polymer solution was subjected to silica column chromatography.

After the column chromatography, a final polymer was obtained by precipitating the resulting product in methanol, putting an obtained polymer powder into a Soxhlet thimble, purifying the resulting product in the order of methanol, acetone, hexane, and chloroform, and then precipitating a portion dissolved in chloroform in methanol, and then filtering the precipitate.

### Example 3. Synthesis of Formula 1-2-1

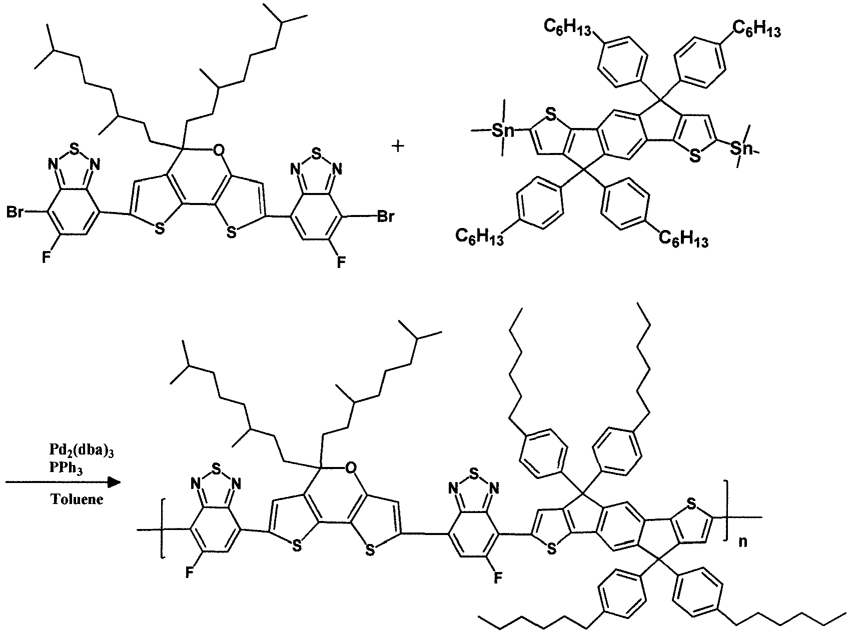

1 mmol of the monomer of Example 1, 1 mmol of an electron donor monomer into which Sn had been introduced, 0.02 mmol of tris(dibenzylideneacetone)dipalladium(0) (Pd₂(dba)₃), and 0.08 mmol of triphenylphosphine were put into a microwave dedicated container, and the mixture was degassed for 5 minutes three times.

And then, 20 mL of dried toluene and 1 mL of dried dimethylformamide (DMF) were added thereto, the mixture was reacted at 120°C for 10 minutes, at 140°C for 10 minutes, and at 150°C for 1 hour, and then cooled to normal temperature, an endcapper was added thereto, and the resulting mixture was reacted at 150°C for 1 hour.

After the reaction, the reaction solution was precipitated in a 1:1 solution of methanol and 1 M hydrochloric acid (HCl), and then filtered, the filtered polymer was dissolved in chlorobenzene, the dissolved solution was mixed with ethylene diamine tetraacetic acid (EDTA) + water (H₂O), and the resulting mixture was reacted at 100°C for 2 hours. After the reaction, the organic layer was separated and washed with water, and then again washed twice with a 3 wt% acetic acid and again with a 5% potassium fluoride, and then an obtained polymer solution was subjected to silica column chromatography.

After the column chromatography, a final polymer was obtained by precipitating the resulting product in methanol, putting an obtained polymer powder into a Soxhlet thimble, purifying the resulting product in the order of methanol, acetone, hexane, and chloroform, and then precipitating a portion dissolved in chloroform in methanol, and then filtering the precipitate.

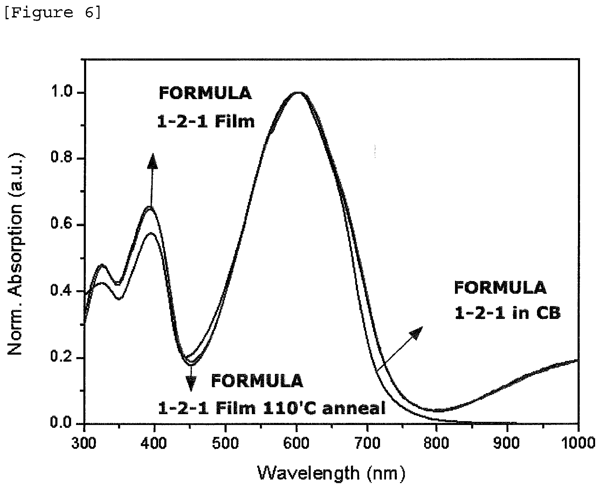

FIG. 6 is a view illustrating the UV spectrum of the polymer prepared in Example 3.

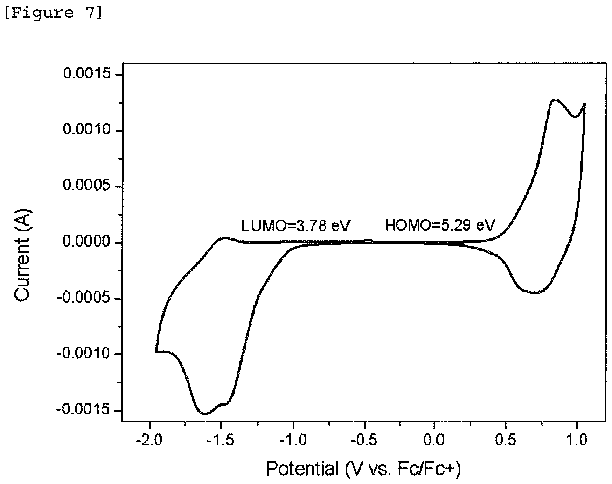

FIG. 7 is a view illustrating the electrochemical measurement result (cyclic voltammetry) of the polymer prepared in Example 3.

### Example 4. Synthesis of Formula 1-3-1

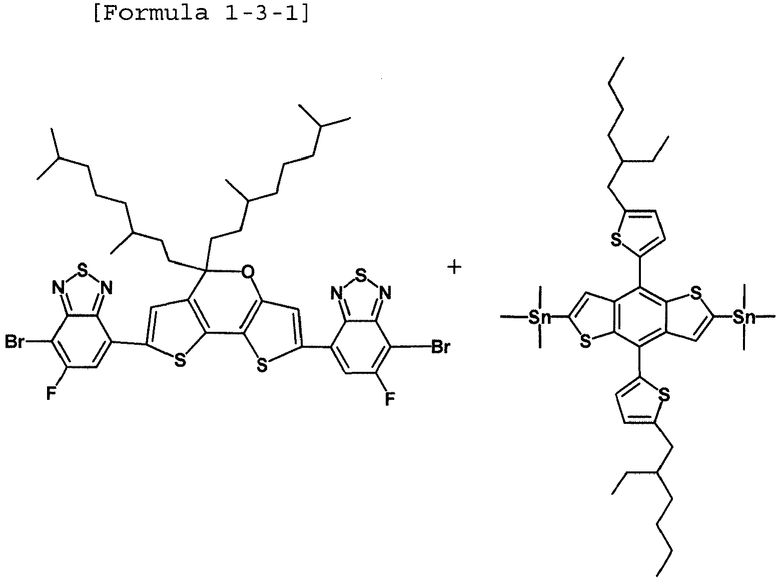

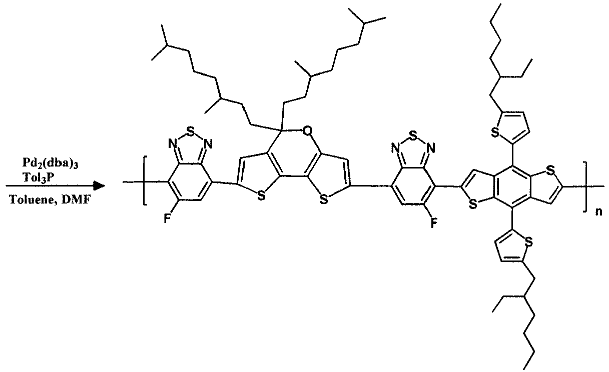

The monomer of Example 1 and an electron donor monomer into which Sn had been introduced were put into a microwave dedicated container. Tri-o-tolyphosphine and tris(dibenzylideneacetone)dipalladium(0) (Pd₂(dba)₃) were added thereto in the argon environment, a vacuum state was created, and 10 ml of toluene and 1 ml of dimethylformamide (DMF) were added thereto.

And then, a reaction was performed at 130°C for 5 minutes, at 140°C for 5 minutes, at 150°C for 30 minutes, and at 160°C for 1 hour and 30 minutes, and then Br-benzotrifluoride was added thereto, and the resulting mixture was reacted at 30°C for 5 minutes, at 140°C for 5 minutes, at 150°C for 30 minutes, and at 160 for 1 hour and 30 minutes.

After the reaction, the reaction solution was precipitated in a solution of methanol and 2 M hydrochloric acid (HCl), the organic layer was washed with water, and then column chromatography was performed using chlorobenzene at high temperature.

After the column chromatography, 447.7 mg of a polymer compound of Formula 1-3-1 was obtained by precipitating the resulting product in methanol and subjecting an obtained polymer powder to Soxhlet extraction with methanol, acetone, hexane, and chloroform.

Number average molecular weight (Mn): 25,600 g/mol Molecular weight distribution (PDI): 1.22

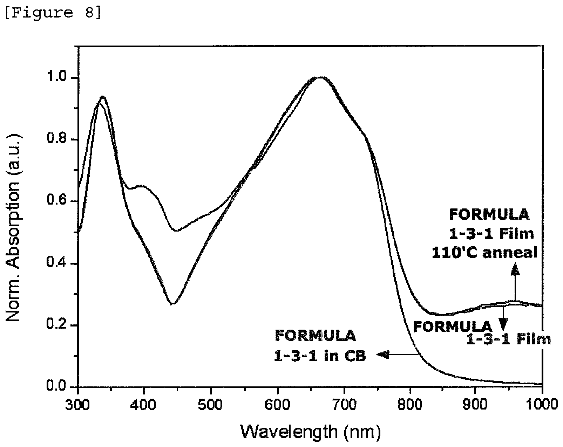

FIG. 8 is a view illustrating the UV spectrum of the polymer prepared in Example 4.

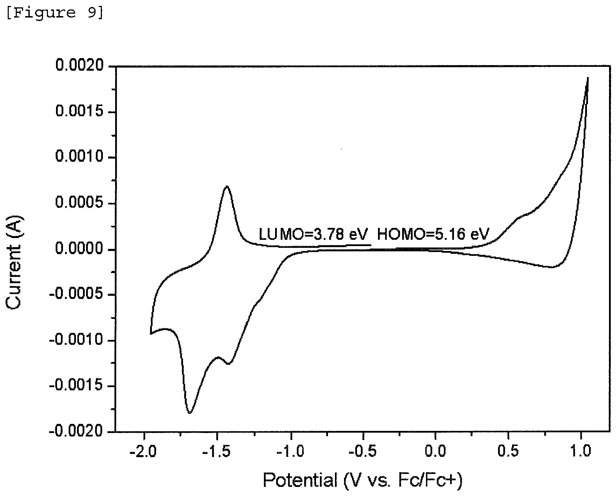

FIG. 9 is a view illustrating the electrochemical measurement result (cyclic voltammetry) of the polymer prepared in Example 4.

### Comparative Example 1. Synthesis of Formula 1-1-2

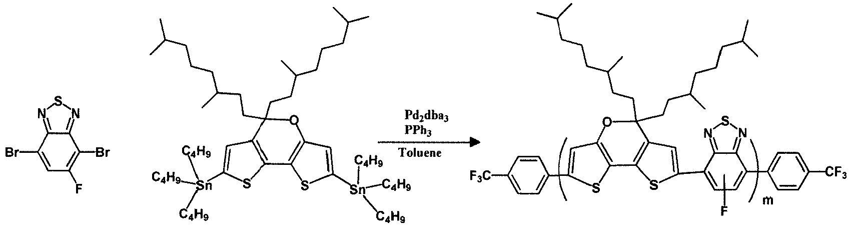

1 mmol of a 4,7-dibromo-5-fluorobenzo[c][1,2,5]thiadiazole (FBTBr₂) monomer, 1 mmol of a monomer into which Sn had been introduced, 0.02 mmol of tris(dibenzylideneacetone)dipalladium(0) (Pd₂(dba)₃), and 0.08 mmol of triphenylphosphine were put into a microwave dedicated container, and the mixture was degassed for 5 minutes three times.

And then, 20 mL of dried toluene and 1 mL of dried dimethylformamide (DMF) were added thereto, the mixture was reacted at 120°C for 10 minutes, at 140°C for 10 minutes, and at 150°C for 1 hour, and then cooled to normal temperature, an endcapper was added thereto, and the resulting mixture was reacted at 150°C for 1 hour.

After the reaction, the reaction solution was precipitated in a 1:1 solution of methanol and 1 M hydrochloric acid (HCl), and then filtered, the filtered polymer was dissolved in chlorobenzene, the dissolved solution was mixed with ethylene diamine tetraacetic acid (EDTA) + water (H₂O), and the resulting mixture was reacted at 100°C for 2 hours. After the reaction, the organic layer was separated and washed with water, and then again washed twice with a 3 wt% acetic acid and again with a 5% potassium fluoride, and then an obtained polymer solution was subjected to silica column chromatography.

After the column chromatography, a final polymer was obtained by precipitating the resulting product in methanol, putting an obtained polymer powder into a Soxhlet thimble, purifying the resulting product in the order of methanol, acetone, hexane, and chloroform, and then precipitating a portion dissolved in chloroform in methanol, and then filtering the precipitate.

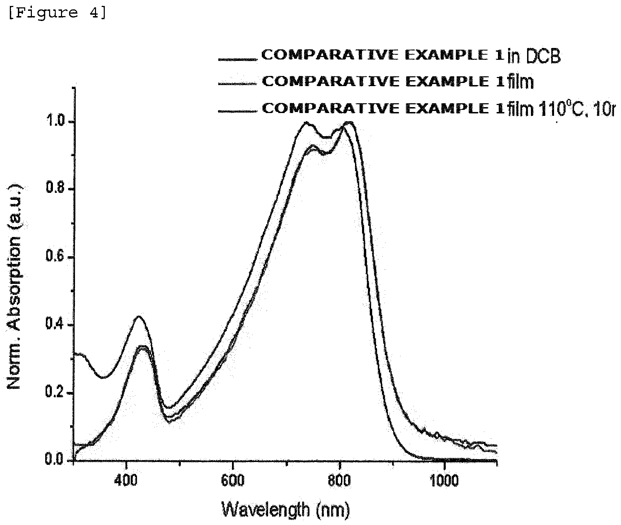

FIG. 4 is a view illustrating the UV spectrum of the polymer represented by Formula 1-1-2.

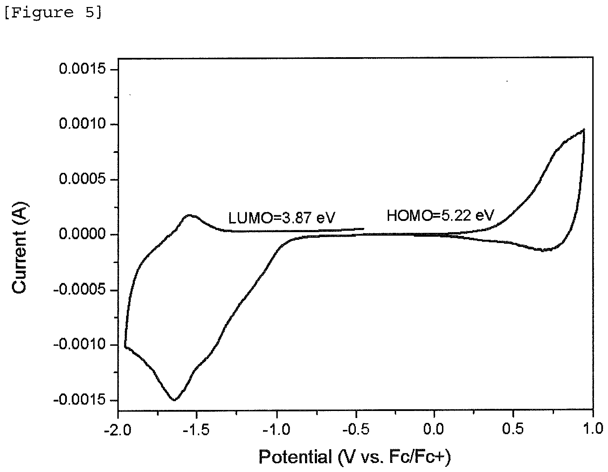

FIG. 5 is a view illustrating the electrochemical measurement result (cyclic voltammetry) of the polymer prepared in Comparative Example 1.

### Examples 1 to 6 and Comparative Examples 1 to 9

A composite solution was prepared by using the prepared polymer as an electron donor and PC₇₀BM as an electron acceptor while setting the blending ratio to the value in the following Table 1 (w/w ratio), and dissolving the mixture in dichlorobenzene (DCB). In this case, the concentration was adjusted to 2.0 wt%, and the organic solar cell was made to have a structure of ITO/PEDOT:PSS/a photoactive layer/Al. A glass substrate coated with ITO was ultrasonically washed using distilled water, acetone, and 2-propanol, the ITO surface was treated with ozone for 10 minutes, followed by heat treatment at 235°C for 5 minutes by spin-coating PEDOT:PSS (AI4083) with a thickness of 45 nm at 4,000 rpm for 40 seconds. In order to coat the photoactive layer, a compound-PCBM composite solution was filtered with a 0.45 µm PP syringe filter and spin-coated, and then an organic solar cell was manufactured by depositing Al to a thickness of 100 nm using a thermal evaporator under a vacuum of 3 x 10⁻⁸ torr.

**[Table 1]**

| | Photoactive layer | rpm | V_{OC} (V) | J_{SC} (mA/cm²) | FF (%) | PCE (%) |
|---|---|---|---|---|---|---|
| Experimental Example 1 | Formula 1-2-1 : PCBM = 1 : 1 (2 wt%) | 800 | 0.8 | 2.33 | 27 | 0.5 |
| Experimental Example 2 | Formula 1-2-1 : PCBM = 1 : 1 (2 wt%) | 1500 | 0.75 | 1.98 | 32 | 0.47 |
| Experimental Example 3 | Formula 1-2-1 : PCBM = 1 : 2 (2 wt%) | 800 | 0.83 | 5.8 | 32 | 1.54 |
| Experimental Example 4 | Formula 1-2-1 : PCBM = 1 : 2 (2 wt%) | 1500 | 0.76 | 4.4 | 3.6 | 1.2 |
| Experimental Example 5 | Formula 1-3-1 : PCBM = 1 : 2 (4.8wt%) | 2500 | 0.75 | 6.2 | 48 | 2.23 |
| Experimental Example 6 | Formula 1-3-1 : PCBM = 1 : 2 (6 wt%) | 2500 | 0.75 | 6.3 | 48 | 2.27 |
| Comparative Example 1 | Formula 1-1-2 : PCBM = 1 : 2 (1 wt%) | 400 | 0.52 | 3.5 | 49 | 0.89 |
| Comparative Example 2 | Formula 1-1-2 : PCBM = 1 : 2 (1 wt%) | 600 | 0.53 | 2.3 | 52 | 0.63 |
| Comparative Example 3 | Formula 1-1-2 : PCBM = 1 : 2 (1 wt%) | 800 | 0.53 | 1.8 | 47 | 0.45 |
| Comparative Example 4 | Formula 1-1-2 : PCBM = 1 : 2 (1 wt%) | 1000 | 0.54 | 1.4 | 50 | 0.4 |
| Comparative Example 5 | Formula 1-1-2 : PCBM = 1 : 2 (2 wt%) | 400 | 0.59 | 4.9 | 44 | 1.27 |
| Comparative Example 6 | Formula 1-1-2 : PCBM = 1 : 2 (2 wt%) | 600 | 0.53 | 5.0 | 45 | 1.19 |
| Comparative Example 7 | Formula 1-1-2 : PCBM = 1 : 2 (2 wt%) | 800 | 0.52 | 4.4 | 48 | 1.1 |
| Comparative Example 8 | Formula 1-1-2 : PCBM = 1 : 2 (2 wt%) | 1000 | 0.53 | 3.9 | 47 | 1.0 |
| Comparative Example 9 | Formula 1-1-2 : PCBM = 1 : 2 (2 wt%) | 1500 | 0.56 | 2.9 | 48 | 0.78 |

In Table 1, V_{oc}, J_{sc}, FF, and PCE mean an open-circuit voltage, a short-circuit current, a fill factor, and energy conversion efficiency, respectively. The open-circuit voltage and the short-circuit current are an X axis intercept and an Y axis intercept, respectively, in the fourth quadrant of the voltage-current density curve, and as the two values are increased, the efficiency of the solar cell is preferably increased. In addition, the fill factor is a value obtained by dividing the area of a rectangle, which may be drawn within the curve, by the product of the short-circuit current and the open circuit voltage. The energy conversion efficiency may be obtained when these three values are divided by the intensity of the irradiated light, and the higher value is preferred.

From the result of Table 1, it was confirmed that the polymer according to an exemplary embodiment of the present specification may be used as a material for an organic solar cell, and it can be confirmed that the polymer has regio-regularity and thus is better than the case where the polymer does not have regio-regularity.

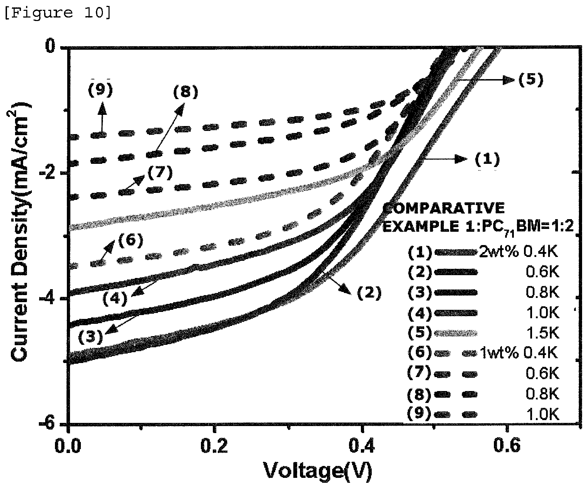

FIG. 10 is a view illustrating the current density according to the voltage of an organic solar cell including the polymer of Comparative Example 1.

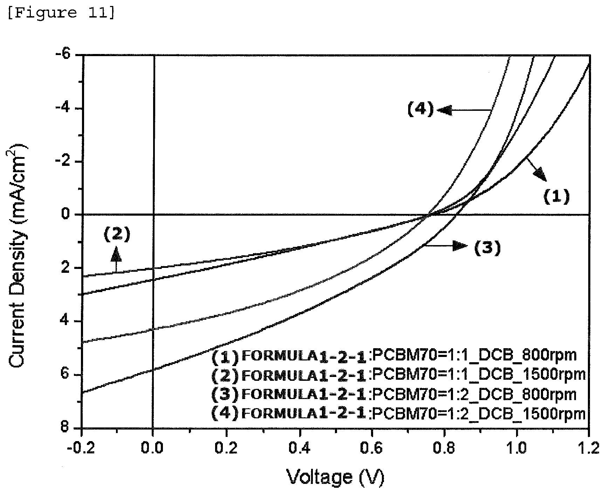

FIG. 11 is a view illustrating the current density according to the voltage of an organic solar cell including the polymer of Example 2.

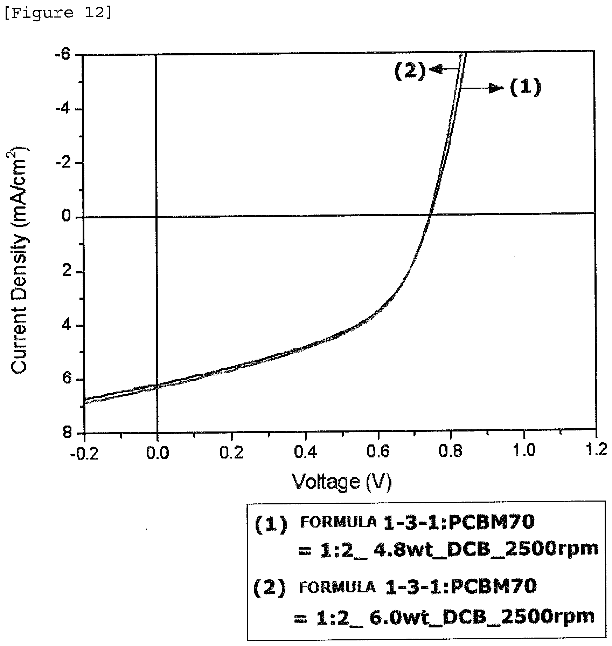

FIG. 12 is a view illustrating the current density according to the voltage of an organic solar cell including the polymer of Example 3.

## Claims

1. A polymer represented by any one of the following Formulae 1-1 to 1-3: 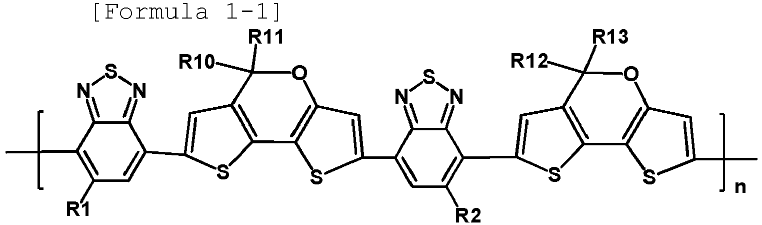 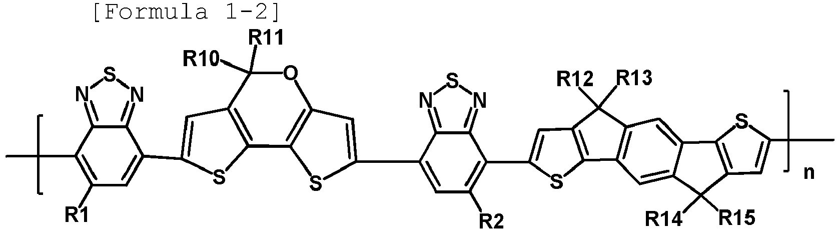 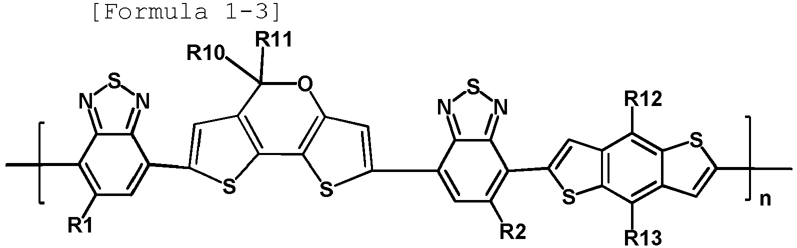 wherein n is an integer of up to 100,000,
R1 and R2 are fluorine, and
R10 to R15 are the same as or different from each other, and are each independently a substituted or unsubstituted straight-chained or branched alkyl group; a substituted or unsubstituted straight-chained or branched alkoxy group; a substituted or unsubstituted cycloalkyl group; a substituted or unsubstituted aryl group; or a substituted or unsubstituted heterocyclic group;
wherein the expression substituted or unsubstituted above means being substituted with one or more substituents selected from deuterium; a halogen group; an alkyl group; an alkenyl group; an alkoxy group; an ester group; a carbonyl group; a carboxyl group; a hydroxyl group; a cycloalkyl group; a silyl group; an arylalkenyl group; an aryloxy group; an alkylthioxy group; an alkylsulfoxy group; an arylsulfoxy group; a boron group; an alkylamine group; an aralkylamine group; an arylamine group; an aryl group; a nitrile group; a nitro group; and a heterocyclic group; or having no substituent.

2. An organic solar cell comprising:
a first electrode;
a second electrode provided to face the first electrode; and
one or more organic material layers provided between the first electrode and the second electrode and comprising a photoactive layer,
wherein one or more layers of the organic material layers comprise the polymer as defined in Claim 1.

3. The organic solar cell of Claim 2, wherein the organic material layer comprises a hole transport layer, a hole injection layer, or a layer which simultaneously transports and injects holes, and
the hole transport layer, the hole injection layer or the layer which simultaneously transports and injects holes comprises the polymer.

4. The organic solar cell of Claim 2, wherein the organic material layer comprises an electron injection layer, an electron transport layer or a layer which simultaneously injects and transports electrons, and
the electron injection layer, the electron transport layer or the layer which simultaneously injects and transports electrons comprises the polymer.

5. The organic solar cell of Claim 2, wherein the photoactive layer comprises one or two or more selected from the group consisting of an electron donor and an electron acceptor, and
the electron donor comprises the polymer.

6. The organic solar cell of Claim 5, wherein the electron acceptor is selected from the group consisting of fullerene, fullerene derivatives, carbon nanotubes, carbon nanotube derivatives, bathocuproine, semiconductive elements, semiconductive compounds or any combination thereof.

7. The organic solar cell of Claim 2, wherein the photoactive layer has a bilayer thin film structure comprising an n-type organic material layer and a p-type organic material layer, and
the p-type organic material layer comprises the polymer.

## Patentansprüche

1. Polymer, dargestellt durch irgendeine der folgenden Formeln 1-1 bis 1-3: 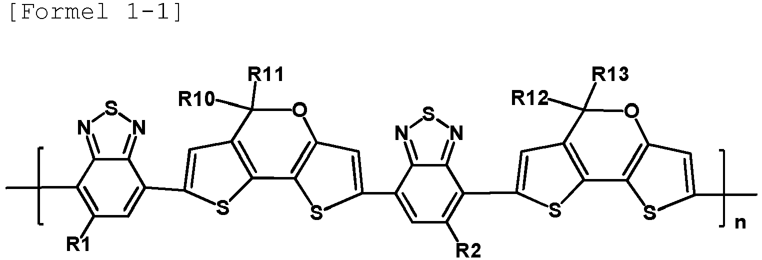 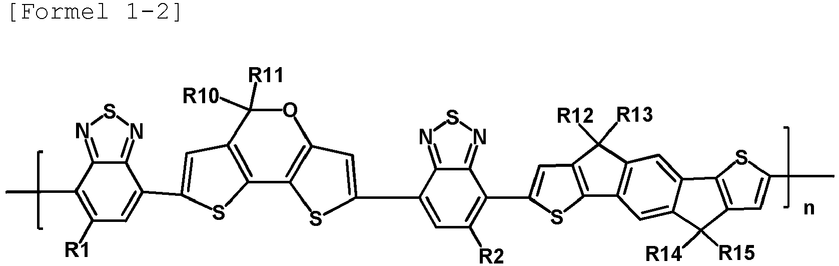 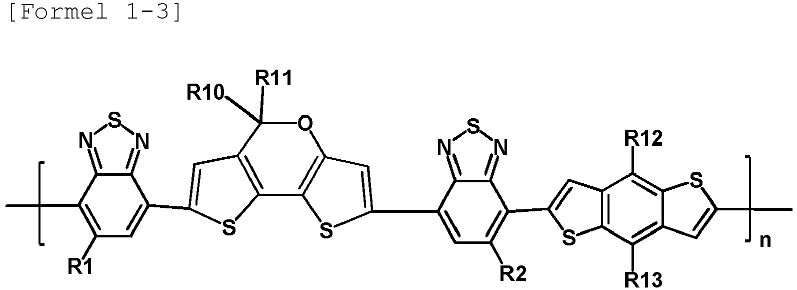 worin n eine ganze Zahl von bis zu 100.000 ist,
R1 und R2 Fluor sind und
R10 bis R15 gleich oder verschieden voneinander sind und jeweils unabhängig eine substituierte oder unsubstituierte geradkettige oder verzweigte Alkylgruppe, eine substituierte oder unsubstituierte geradkettige oder verzweigte Alkoxygruppe, eine substituierte oder unsubstituierte Cycloalkylgruppe, eine substituierte oder unsubstituierte Arylgruppe oder eine substituierte oder unsubstituierte heterocyclische Gruppe sind,
wobei der vorstehende Ausdruck substituiert oder unsubstituiert substituiert mit einem oder mehreren Substituenten, ausgewählt aus Deuterium, einer Halogengruppe, einer Alkylgruppe, einer Alkenylgruppe, einer Alkoxygruppe, einer Estergruppe, einer Carbonylgruppe, einer Carboxylgruppe, einer Hydroxylgruppe, einer Cycloalkylgruppe, einer Silylgruppe, einer Arylalkenylgruppe, einer Aryloxygruppe, einer Alkylthioxygruppe, einer Alkylsulfoxygruppe, einer Arylsulfoxygruppe, einer Borgruppe, einer Alkylamingruppe, einer Aralkylamingruppe, einer Arylamingruppe, einer Arylgruppe, einer Nitrilgruppe, einer Nitrogruppe und einer heterocyclischen Gruppe, oder ohne Substituenten bedeutet.

2. Organische Solarzelle, umfassend:
eine erste Elektrode,
eine zweite Elektrode, die so angeordnet ist, dass sie die der ersten Elektrode gegenübersteht, und
eine oder mehrere organische Materialschichten, die zwischen der ersten Elektrode und der zweiten Elektrode angeordnet sind und eine photoaktive Schicht umfassen,
wobei eine oder mehrere der organischen Materialschichten das in Anspruch 1 definierte Polymer umfassen.

3. Organische Solarzelle gemäß Anspruch 2, wobei die organische Materialschicht eine Lochtransportschicht, eine Lochinjektionsschicht oder eine Schicht, die gleichzeitig Löcher transportiert und injiziert, umfasst und
die Lochtransportschicht, die Lochinjektionsschicht und die Schicht, die gleichzeitig Löcher transportiert und injiziert, das Polymer umfasst.

4. Organische Solarzelle gemäß Anspruch 2, wobei die organische Materialschicht eine Elektroneninjektionsschicht, eine Elektronentransportschicht oder eine Schicht, die gleichzeitig Elektronen injiziert und transportiert, umfasst, und
die Elektroneninjektionsschicht, die Elektronentransportschicht oder die Schicht, die gleichzeitig Elektronen injiziert und transportiert, das Polymer umfasst.

5. Organische Solarzelle gemäß Anspruch 2, wobei die photoaktive Schicht einen oder zwei oder mehrere, ausgewählt aus der Gruppe, bestehend aus einem Elektronendonor und einem Elektronenakzeptor, umfasst und
der Elektronendonor das Polymer umfasst.

6. Organische Solarzelle gemäß Anspruch 5, wobei der Elektronenakzeptor aus der Gruppe, bestehend aus Fulleren, Fullerenderivaten, Kohlenstoff-Nanoröhrchen, Kohlenstoff-Nanoröhrchenderivaten, Bathocuproin, Halbleiterelementen, Halbleiterverbindungen oder irgendeiner Kombination davon, ausgewählt ist.

7. Organische Solarzelle gemäß Anspruch 2, wobei die photoaktive Schicht eine zweischichtige Dünnfilmstruktur aufweist, die eine organische Materialschicht vom n-Typ und eine organische Materialschicht vom p-Typ umfasst, und
die organische Materialschicht vom p-Typ das Polymer umfasst.

## Revendications

1. Polymère représenté par l'une quelconque des formules 1-1 à 1-3 suivantes : 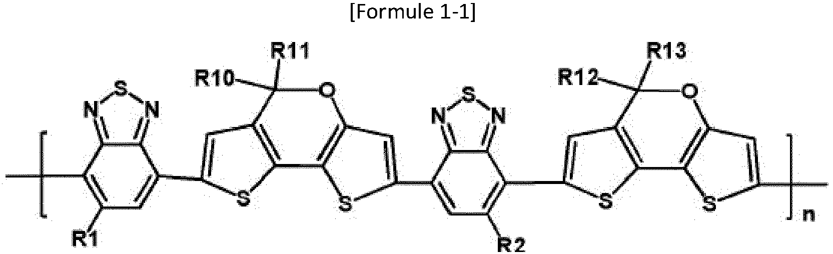 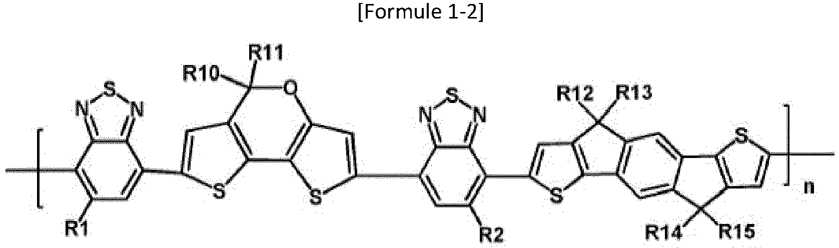 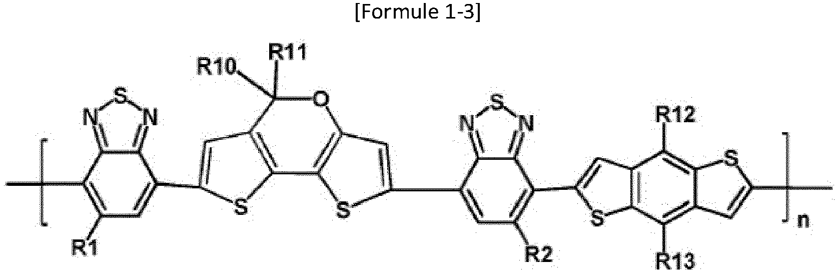 dans lesquelles n est un nombre entier allant jusqu'à 100 000,
R1 et R2 sont un fluor, est
R10 à R15 sont identiques les uns aux autres ou différents les uns des autres, et sont chacun indépendamment un groupe alkyle à chaîne linéaire ou ramifiée substitué ou non substitué ; un groupe alcoxy à chaîne linéaire ou ramifiée substitué ou non substitué ; un groupe cycloalkyle substitué ou non substitué ; un groupe aryle substitué ou non substitué ; ou un groupe hétérocyclique substitué ou non substitué ;
dans lequel l'expression substitué ou non substitué ci-dessus signifie être substitué avec un ou plusieurs substituants sélectionnés parmi un deutérium ; un groupe halogène ; un groupe alkyle ; un groupe alcényle ; un groupe alcoxy ; un groupe ester ; un groupe carbonyle ; un groupe carboxyle ; un groupe hydroxyle ; un groupe cycloalkyle ; un groupe silyle ; un groupe arylalcényle ; un groupe aryloxy ; un groupe alkylthioxy; un groupe alkylsulfoxy ; un groupe arylsulfoxy ; un groupe bore ; un groupe alkylamine ; un groupe aralkylamine ; un groupe arylamine ; un groupe aryle ; un groupe nitrile ; un groupe nitro ; et un groupe hétérocyclique ; ou ne présenter aucun substituant.

2. Cellule solaire organique comprenant :
une première électrode ;
une seconde électrode fournie en face de la première électrode ; et
une ou plusieurs couches de matériau organique fournies entre la première électrode et la seconde électrode et comprenant une couche photoactive,
dans laquelle une ou plusieurs couches des couches de matériau organique comprennent le polymère tel que défini dans la revendication 1.

3. Cellule solaire organique selon la revendication 2, dans laquelle la couche de matériau organique comprend une couche de transport de trous, une couche d'injection de trous, ou une couche qui transporte et injecte simultanément des trous, et
la couche de transport de trous, la couche d'injection de trous ou la couche qui transporte et injecte simultanément des trous comprend le polymère.

4. Cellule solaire organique selon la revendication 2, dans laquelle la couche de matériau organique comprend une couche d'injection d'électrons, une couche de transport d'électrons ou une couche qui injecte et transporte simultanément des électrons, et
la couche d'injection d'électrons, la couche de transport d'électrons ou la couche qui injecte et transporte simultanément des électrons comprend le polymère.

5. Cellule solaire organique selon la revendication 2, dans laquelle la couche photoactive comprend un ou deux ou plus de deux sélectionnés dans le groupe consistant en un donneur d'électrons et un accepteur d'électrons, et
le donneur d'électrons comprend le polymère.

6. Cellule solaire organique selon la revendication 5, dans laquelle l'accepteur d'électrons est sélectionné dans le groupe consistant en un fullerène, les dérivés de fullerène, les nanotubes de carbone, les dérivés de nanotubes de carbone, la bathocuproïne, les éléments semi-conducteurs, les composés semi-conducteurs et n'importe quelle combinaison de ceux-ci.

7. Cellule solaire organique selon la revendication 2, dans laquelle la couche photoactive présente une structure bicouche à film mince comprenant une couche de matériau organique de type n et une couche de matériau organique de type p, et
la couche de matériau organique de type p comprend le polymère.
